# FASCICULE DE BREVET EUROPEEN

(11) **EP 1 877 811 B1**
(45) Date de publication et mention de la délivrance du brevet: **15.04.2009**
(21) Numéro de dépôt: 06743720.2
(22) Date de dépôt: 21.04.2006
(51) Int. Cl.: G01R 31/317, G01R 31/3185

(54) **CIRCUIT INTEGRE COMPORTANT UN MODE DE TEST SECURISE PAR DETECTION DE L ETAT CHAINE DES CELLULES CONFIGURABLES DU CIRCUIT INTEGRE**
INTEGRIERTE SCHALTUNG MIT EINEM SICHEREN PRÜFMODUS, DER INTEGRIERTE-SCHALTUNGS-KONFIGURIERBARE ZELLENKETTENSTATUSDETEKTION VERWENDET
INTEGRATED CIRCUIT COMPRISING A SECURE TEST MODE USING INTEGRATED CIRCUIT CONFIGURABLE CELL CHAIN STATUS DETECTION

(30) Priorité: 04.05.2005 FR 0504526
(43) Date de publication de la demande: 16.01.2008
(73) Titulaire: STMicroelectronics SA, F-92120 Montrouge (FR)
(72) Inventeur: BANCEL, Frédéric, F-13113 Lamanon (FR); HELY, David, F-13170 Les Pennes Mirabeau (FR)
(74) Mandataire: Bouchet, Geneviève
(86) Numéro de dépôt international: PCT/FR2006/000901
(87) Numéro de publication internationale: WO 2006/120315

(56) Documents cités:
- EP-A- 1 089 083
- US-A1- 2003 204 801
- HELY D ET AL: "Test Control for Secure Scan Designs" TEST SYMPOSIUM, 2005. EUROPEAN TALLINN, ESTONIA 22-25 MAY 2005, PISCATAWAY, NJ, USA,IEEE, 22 mai 2005 (2005-05-22), pages 190-195, XP010801332 ISBN: 0-7695-2341-2

## Description

L'invention concerne, de façon générale, les circuits électroniques intégrés synchrones munis de moyens de logique combinatoire, de bascules, et de moyens de test. Plus précisément, l'invention concerne un circuit électronique comprenant une pluralité de cellules configurables configurées par un circuit de commande tel qu'un contrôleur d'accès lorsqu'il reçoit un signal de commande de mode :
- soit dans un état fonctionnel dans lequel les cellules configurables sont fonctionnellement reliées à des cellules logiques avec lesquelles elles coopèrent pour former au moins un circuit logique, si le signal de commande de mode est dans un premier état, par exemple inactif,
- soit dans un état chaîné dans lequel les cellules configurables sont fonctionnellement connectées en chaîne pour former un registre à décalage, si le signal de commande de mode est dans un deuxième état, par exemple actif.

Il est aujourd'hui bien connu de vérifier le fonctionnement correct des éléments fonctionnels d'un circuit intégré en imposant et / ou en déterminant, à des instants prédéfinis, des valeurs de données présentes en certains points internes de ce circuit intégré. Une telle technique de test des chemins internes d'un circuit intégré (désignée par "scanpath" ou "internal scan method" en langue anglaise) est par exemple décrite dans la publication de M. Williams et J. Angel, intitulée "Enhancing Testability of LSI Circuits Via Test Points and Additional Logic, IEEE Transactions on Computers, vol. C-22, no.1; Janvier 1973" et dans EP1089083 et US 2003/204801.

Selon cette technique, chacune des bascules du circuit logique, dont il est utile de connaître l'état et / ou d'imposer le contenu durant le fonctionnement standard du circuit intégré, est dotée à son entrée d'un multiplexeur. Les différentes bascules et les multiplexeurs qui leur sont associés constituent ainsi autant de cellules configurables dont les accès sont contrôlés par ces multiplexeurs.

Les multiplexeurs de ces différentes cellules configurables sont collectivement commandés par un contrôleur d'accès ou "contrôleur TAP" ("TAP" pour "Test Access Port" en langue anglaise) qui, en fonction d'un signal de commande définissant un mode de fonctionnement choisi, utilise cet ensemble de cellules configurables soit comme un circuit fonctionnel standard, intégré au circuit logique qu'il forme avec les cellules logiques, soit comme un circuit de test.

Pour ce faire, le contrôleur TAP reçoit sur différents conducteurs de commande, et / ou adresse sur différents conducteurs de commande par lesquels il est relié aux différentes cellules configurables, des signaux de commande, tels qu'un signal de commande de mode, un signal de commande de chaînage ou encore un signal de commande de propagation de données, qui autorisent à modifier et / ou modifient les chemins de circulation des données au sein du circuit intégré et qui permettent ainsi la capture de ces données par le contrôleur, en vue de leur analyse ultérieure.

En mode de fonctionnement standard, le contrôleur TAP pilote donc les multiplexeurs des cellules configurables de manière que les bascules de ces cellules soient connectées à des cellules logiques environnantes pour définir un ou plusieurs sous-ensembles fonctionnels du circuit intégré.

Dans le mode de test, qui est normalement déclenché à réception par le contrôleur TAP d'un signal de commande de passage en mode de test, ce contrôleur produit un signal de commande de chaînage pour connecter en série les bascules des cellules configurables de manière à former un registre à décalage.

Ce registre comporte notamment une entrée série et une sortie série respectivement connectées à une sortie et à une entrée du contrôleur TAP, ainsi qu'une entrée d'horloge recevant un signal d'horloge pour cadencer le flot de données.

Dans un premier temps, le contrôleur TAP charge en série des données dans les bascules des cellules configurables par l'entrée du registre à décalage que forment ces cellules configurables.

Puis, le contrôleur TAP change la commutation des multiplexeurs pour former le circuit fonctionnel, et commande l'exécution d'un ou plusieurs cycles d'horloge par ce circuit fonctionnel. Dans cette phase, les données chargées dans les bascules des cellules configurables sont traitées par le circuit fonctionnel.

Le contrôleur change alors une nouvelle fois la commutation des multiplexeurs pour former à nouveau le registre à décalage et récupère, en série sur la sortie de ce registre à décalage, les données mémorisées dans les bascules des cellules configurables durant le dernier cycle d'horloge.

En dépit de l'intérêt confirmé de cette technique de test, son application pratique peut en certaines circonstances s'avérer problématique, notamment sur les circuits intégrés qui traitent des données secrètes.

En effet, dans la mesure où l'activation du mode de test peut permettre à un fraudeur de lire le contenu des bascules des cellules configurables, cette technique de test présente a priori l'inconvénient de rendre de tels circuits très vulnérables à une utilisation frauduleuse.

Par exemple, en stoppant à divers moments un processus de chargement interne de données secrètes dans le circuit intégré et en déchargeant le contenu du registre à décalage, un fraudeur pourra obtenir des informations sur des données secrètes, voire les reconstituer.

En activant le mode de test, un fraudeur pourra également accéder en écriture aux bascules des cellules configurables pour insérer des données frauduleuses, ou bien pour placer le circuit intégré dans une configuration non autorisée. Il pourra ainsi par exemple accéder à un registre contrôlant un organe sécuritaire tel qu'un capteur pour le désactiver. Il pourra également injecter une donnée erronée en vue d'obtenir de l'information sur une donnée secrète.

La fraude peut en fait adopter deux stratégies différentes : la première consiste à prendre le contrôle du contrôleur TAP et à observer sur les plots externes le contenu des cellules du registre à décalage ; la seconde consiste à prendre le contrôle des cellules configurables en les excitant par micro-sondage de manière à simuler le pilotage de ces cellules par les signaux de commande qu'émet le contrôleur TAP.

Le but de la présente invention est précisément de proposer un circuit électronique conçu pour faire échec à une tentative de fraude conforme à la seconde stratégie évoquée ci-dessus.

Pour atteindre cet objectif, le circuit selon l'invention, par ailleurs conforme à la définition générique qu'en donne le préambule ci-dessus, est essentiellement caractérisé en ce qu'il comprend également un circuit de détection agencé pour produire un signal d'état actif s'il détecte un état chaîné des cellules configurables alors que le circuit de commande reçoit le signal de commande de mode dans le premier état.

Lorsque le signal de commande de mode est dans le premier état, par exemple inactif, les cellules configurables devraient être en mode standard. Si le circuit de détection détecte que les cellules configurables sont dans un état chaîné, alors cela signifie une tentative d'intrusion, que le circuit de détection signale par un signal d'état actif.

Le circuit de détection selon l'invention comprend de préférence une cellule d'état qui est :
- fonctionnellement connectée en chaîne entre une cellule configurable précédente et une cellule configurable suivante si les cellules configurables sont dans l'état chaîné, la dite cellule d'état produisant un signal de sortie représentatif du contenu de la chaîne, ou
- fonctionnellement isolée si les cellules configurables sont dans l'état fonctionnel, la dite cellule d'état produisant alors un signal de sortie représentatif d'une valeur de référence, et le circuit de détection comprend également un circuit de comparaison pour comparer le signal de sortie avec la valeur de référence lorsqu'il reçoit le signal d'état, et produire le signal d'état actif si la valeur du signal de sortie est différente de la valeur de référence.

Selon un premier mode de réalisation, le circuit de détection comprend une unique cellule d'état, et un circuit de comparaison approprié pour traiter le signal produit par cette unique cellule d'état.

Selon un autre mode de réalisation, le circuit de détection comprend plusieurs cellules d'état qui sont :
- fonctionnellement connectées en chaîne avec les cellules configurables si les cellules configurables sont dans l'état chaîné, chaque cellule d'état étant connectée entre une cellule configurable précédente et une cellule configurable suivante, chaque cellule d'état produisant un signal de sortie représentatif du contenu de la chaîne, ou
- fonctionnellement isolées si les cellules configurables sont dans l'état fonctionnel, chaque cellule d'état produisant alors un signal de sortie représentatif d'une valeur de référence parmi un ensemble de valeurs de référence, et le circuit de détection comprend également un circuit de comparaison pour comparer le signal de sortie de chaque cellule d'état avec une valeur de référence associée lorsqu'il reçoit le signal de commande dans le premier état, et produire le signal d'état actif si la valeur d'un des signaux de sortie est différente de la valeur de référence associée.

Au moins une cellule d'état comprend une première entrée de données sur laquelle est appliqué un signal dont le potentiel est à la valeur neutre, une deuxième entrée de données connectée à une sortie de la cellule configurable précédente, une troisième entrée de sélection connectée au circuit de commande et une sortie connectée d'une part à la cellule configurable suivante et d'autre part à une première entrée de données du circuit de comparaison. La valeur de référence étant appliquée sur une deuxième entrée de données du circuit de comparaison.

La cellule configurable comprend également de préférence:
- une bascule ayant une sortie connectée à la sortie de la dite cellule configurable, et
- un multiplexeur ayant une première entrée de données et une deuxième entrée de données connectées respectivement à la première entrée et à la deuxième entrée de la cellule configurable, une entrée de sélection connectée à la troisième entrée de la dite cellule configurable, et une sortie connectée à une entrée de données de la bascule.

Le circuit de comparaison peut quant à lui comprendre :
- un circuit de logique combinatoire, pour combiner entre eux les signaux de sortie de plusieurs cellules d'état, et
- un moyen pour comparer le résultat de la combinaison avec la valeur de référence lorsqu'il reçoit le signal de commande de mode, et produire le signal d'état actif si le résultat de la combinaison est différent de la valeur de référence.

Enfin, au moins une cellule configurable est réalisée de préférence de manière similaire à une cellule d'état, la première entrée de données de la dite cellule configurable étant connectée à une sortie d'une cellule logique avec laquelle elle coopère.

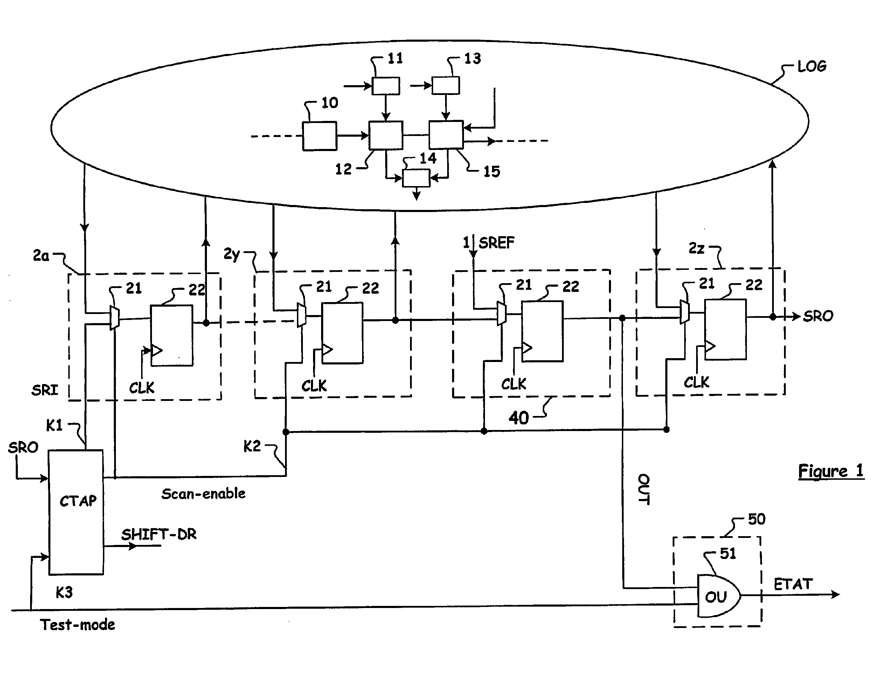

L'invention sera mieux comprise et d'autres caractéristiques et avantages apparaîtront à la lecture de la description qui va suivre, d'un exemple de mise en oeuvre d'un circuit comprenant un mode de test sécurisé selon l'invention. La description, faite à titre indicatif et nullement limitatif, est à lire en relation aux dessins annexés dans lesquels :
e la figure 1 est un schéma électronique d'un premier mode de réalisation de l'invention, et

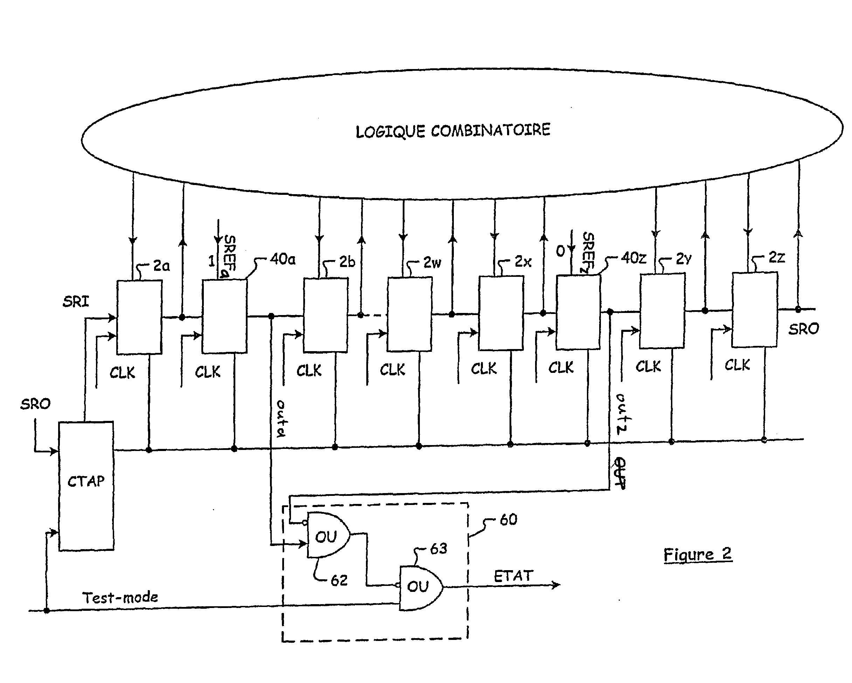

• la figure 2 est un schéma électronique d'un deuxième mode de réalisation de l'invention.

Comme annoncé précédemment, l'invention concerne un circuit électronique doté de moyens de test internes.

Un tel circuit comprend typiquement une pluralité de cellules logiques telles que les cellules 10 à 15, une pluralité de cellules configurables telles que les cellules 2a à 2y, 2z, une pluralité de conducteurs de commande tels que les conducteurs K1 à K3, ainsi éventuellement qu'un circuit de commande tel qu'un contrôleur d'accès CTAP, qui peut aussi, toutefois, être externe au circuit électronique considéré.

Chacune des cellules configurables 2a à 2z comprend :
- une première entrée de données connectée à au moins une des cellules logiques 10 à 15 du circuit LOG,
- une deuxième entrée de données connectée à une sortie d'une cellule configurable précédente,
- une entrée d'horloge sur laquelle est appliqué le signal CLK et une entrée de commande sur laquelle est appliqué une signal SCAN_ENABLE,
- une sortie connectée à la deuxième entrée d'une cellule configurable suivante et à au moins une des cellules logiques 10 à 15 du circuit LOG.

Chaque cellule configurable comprend au moins un multiplexeur 21 et au moins une bascule 22 : deux entrées du multiplexeur sont connectées aux entrées de la cellule configurable, une sortie du multiplexeur est connectée à l'entrée de la bascule 22 dont une sortie forme la sortie de la cellule configurable.

Les conducteurs de commande K1 à K3, dont certains au moins sont reliés aux cellules configurables 2a à 2y, 2z, servent à la transmission de signaux de commande sélectivement reçus et / ou émis en fonctionnement par le circuit de commande CTAP, tels qu'un signal de commande de passage en mode de test TEST_MODE qui active le circuit de commande CTAP, le signal de commande de chaînage SCAN_ENABLE qui chaîne les cellules configurables sous forme d'un registre à décalage, et un signal de commande SHIFT_DR qui permet la propagation de données dans les cellules configurables.

En fonction de ces signaux de commande ou de certains au moins d'entre eux, les cellules configurables 2a à 2y, 2z adoptent :
- soit un mode de fonctionnement standard, dans lequel elles sont fonctionnellement reliées à certaines au moins des cellules logiques 10 à 15 avec lesquelles elles coopèrent pour former un circuit logique LOG,
- soit un mode de test dans lequel ces cellules configurables 2a à 2z sont fonctionnellement connectées l'une à l'autre en chaîne pour former un registre à décalage.

Le passage des cellules configurables du mode de fonctionnement standard au mode de test est effectué par le pilotage des multiplexeurs 21 au moyen du signal de commande SCAN_ENABLE délivré par le circuit de commande CTAP.

Le registre à décalage 2a à 2z présente notamment une entrée de données SRI pilotée par une sortie du circuit de commande CTAP, une sortie de données SRO, reliée à une entrée du circuit de commande CTAP, et une entrée d'horloge (non spécifiquement représentée) pour recevoir un signal d'horloge CLK propre à cadencer le flot de données dans ce registre à décalage.

Pour lancer un test, un signal TEST_MODE de commande de passage en mode de test doit d'abord être adressé au circuit de commande CTAP. Le circuit de commande CTAP configure alors les cellules configurables 2a à 2z en registre à décalage par l'émission du signal de commande de chaînage SCAN_ENABLE.

Puis, par émission du signal de commande de propagation CLK, le circuit de commande CTAP charge en série des données de test dans les bascules 22 de ces cellules configurables à travers l'entrée SRI du registre à décalage.

Puis, par désactivation du signal de commande de chaînage SCAN_ENABLE, le circuit de commande CTAP reconfigure les cellules configurables 2a à 2z en élément fonctionnel du circuit logique LOG et commande l'exécution d'un ou plusieurs cycles d'horloge par cet élément fonctionnel, qui traite les données de test.

Par réactivation du signal de commande de chaînage SCAN_ENABLE, le circuit de commande CTAP reconfigure à nouveau les cellules configurables 2a à 2z en registre à décalage.

Enfin, par émission du signal de commande de propagation CLK, le circuit de commande CTAP récupère, à la sortie SRO de ce registre, les données mémorisées dans les bascules 22 et issues du traitement des données de test par le circuit logique LOG.

Pour éviter notamment qu'un fraudeur ne puisse simuler une telle procédure de test en appliquant directement des signaux de commande sur les conducteurs K1 à K3, et / ou des données sur l'entrée SRI, et ne puisse récupérer ainsi frauduleusement les données mémorisées dans les bascules 22 et issues du traitement des données de test par le circuit logique LOG, le circuit électronique de l'invention comprend un circuit de détection d'état 30.

Ce circuit de détection d'état 30 a pour fonction, lorsque le circuit intégré est en fonctionnement normal (signal TEST_MODE inactif), de délivrer un signal OUT représentatif de l'état non chaîné (signifiant une absence d'anomalie) ou de l'état chaîné (signifiant une tentative d'intrusion) des cellules configurables.

En effet, en fonctionnement normal, le signal TEST_MODE est inactif, le circuit CTAP délivre un signal de commande de chaînage SCAN_ENABLE inactif, et les cellules configurables sont normalement dans un état non chaîné.

Aussi, si le circuit de détection d'état détecte que les cellules configurables sont configurées en registre à décalage (état chaîné), cela signifie nécessairement une tentative d'intrusion.

Dans un premier mode de réalisation de l'invention, le circuit de détection d'état 30 comporte une cellule d'état 40 et un circuit de détection 50.

La cellule 40 est réalisée de préférence selon un schéma électronique similaire au schéma électronique des cellules configurables. Les deux principales différences sont les suivantes :
- un signal de référence SREF est appliqué sur la première entrée de la cellule d'état, qui n'est donc pas connectée à une des cellules logiques du circuit LOG, et
- la sortie de la cellule d'état est connectée à une entrée du circuit de comparaison 50, et non pas à une des cellules logiques du circuit LOG.

La cellule d'état comprend, de même qu'une cellule configurable, un multiplexeur 21 et une bascule 22, connectés de manière similaire.

Le signal SCAN_ENABLE est appliqué sur une entrée de sélection du multiplexeur 21 et le signal d'horloge CLK est appliqué sur une entrée d'horloge de la bascule 22.

Ainsi réalisée, la cellule d'état 40 est :
- fonctionnellement connectée en chaîne entre la cellule configurable précédente 2y et la cellule configurable suivante 2z si les cellules configurables sont dans l'état chaîné ; la dite cellule d'état 40 produit dans ce cas un signal de sortie OUT représentatif du contenu de la chaîne, ou
- fonctionnellement isolée si les cellules configurables sont dans l'état fonctionnel ; la cellule d'état 40 produit alors un signal de sortie OUT représentatif de la valeur du signal de référence SREF (la valeur "1" dans l'exemple de la figure 1) appliqué sur sa première entrée de données.

Le circuit de comparaison 50 a pour fonction de vérifier que le signal de sortie OUT de la cellule d'état est égal à la valeur de référence qui est appliquée sur sa première entrée et de signaler, lorsque le circuit est en mode de fonctionnement normal (signal TEST_MODE inactif, ici à 0):
- soit une absence d'anomalie si le signal de sortie OUT a la valeur attendue (dans l'exemple la valeur 1); dans ce cas, ETAT = 1, inactif,
- soit une tentative d'intrusion, si le signal de sortie OUT a une valeur différente de la valeur attendue ; dans ce cas, ETAT = 0, actif.

Dans le premier mode de réalisation, tel que représenté sur la figure 1, le circuit de comparaison 50 comprend une porte logique, de type OU, comprenant une première entrée connectée à la sortie de la cellule 40 et une deuxième entrée sur laquelle est appliqué le signal TEST_MODE.

Le fonctionnement du circuit de détection selon la figure 1 est le suivant. En mode de test du circuit intégré, le signal TEST_MODE est actif (ici actif à "1"), la porte OU 51 produit dans ce cas un signal inactif ETAT = 1.

Par contre, en mode de fonctionnement standard du circuit intégré, le signal TEST_MODE est inactif (ici inactif à "0") et, si le signal OUT en sortie de la cellule 40 est égal à "0" (c'est-à-dire s'il est différent du signal SREF appliqué sur la première entrée de la cellule 40), cela signifie que le signal en sortie de la cellule d'état provient nécessairement de la sortie de la cellule configurable 2y précédant la cellule d'état 40, en d'autres termes, que les cellules configurables et la cellule d'état sont chaînées. La porte OU 50 délivre dans ce cas un signal actif ETAT = 0, pour indiquer une tentative d'intrusion.

On notera que le circuit de détection tel que décrit ci-dessus n'est efficace que si la donnée contenue dans la cellule configurable précédent la cellule d'état contient autre chose que la valeur de référence (ici, un "1" appliquée sur la première entrée de la cellule d'état.
Toutefois, lors d'une tentative d'intrusion, un fraudeur va tenter d'entrer des données dans le registre à décalage, ou au contraire de sortir des données du registre ; dans les deux cas, cela suppose de déplacer des données à l'intérieur du registre. Comme il est très peu probable que les données du registre soient toutes égales à la valeur de référence, le circuit de détection sera efficace rapidement, après quelques fronts actifs du signal d'horloge.

Sur la figure 2 est représenté un deuxième mode de réalisation, plus efficace, d'un circuit de détection selon l'invention, qui comprend plusieurs cellules d'état 40a, ... 40z (seules deux sont représentées par souci de simplification), et un circuit de comparaison 60.

Les cellules d'état 40a, ..., 40z sont réalisées par exemple de manière identiques à la cellule 40 de la figure 1, avec un multiplexeur 21 et une bascule 22, et sont connectées de manière similaire. Le choix du nombre de cellules d'état est un compromis entre la sécurité du circuit d'une part, et la taille et la rapidité du circuit d'autre part : plus le nombre de cellules d'état est important et plus une tentative d'intrusion peut être détectée rapidement, mais plus le circuit est volumineux et lent en mode de test. Dans un exemple préféré, on choisit un nombre de cellules d'état de l'ordre d'environ 5% du nombre de cellules configurables.

On applique sur la première entrée de chacune des cellules d'état 40a à 40z un signal de référence SREFa à SREFz égal à un "1" ou un "0" logique, au choix, la valeur appliquée pouvant être différente d'une cellule d'état à l'autre. Chaque cellule d'état produit un signal de sortie OUTa à OUTz qui est égal à la valeur appliquée sur sa première entrée ou à la valeur présente en sortie de la cellule configurable précédente, selon la valeur du signal de commande SCAN_ENABLE appliquée sur son entrée de commande.

Les cellules d'état sont réparties entre les cellules configurables du registre à décalage, de préférence de manière aléatoire, ceci afin d'éviter que la position des cellules d'état puisse être repérée et exploitée par un éventuel fraudeur.

Le circuit de comparaison 60 a pour fonction de vérifier que le signal de sortie OUTa à OUTz de chaque cellule d'état est égal à la valeur de référence qui est appliquée sur sa première entrée et de signaler, lorsque le circuit est en mode de fonctionnement normal (signal TEST_MODE = 0, inactif) :
- soit une absence d'anomalie si les signaux de sortie OUTa, ..., OUTz ont tous la valeur attendue ; dans ce cas, ETAT = 1, inactif,
- soit une tentative d'intrusion, si l'un au moins des signaux de sortie OUTa, ..., OUTz a une valeur différente de la valeur attendue pour ce signal ; dans ce cas, ETAT = 0, actif.

Dans le cas d'un circuit de détection selon la figure 2, comportant deux cellules d'état 40a et 40z, le circuit de comparaison peut comprendre deux portes logiques 62, 63.

La porte 63 est de type OU, elle comprend une entrée non inverseuse sur laquelle est appliquée le signal OUTa et une entrée inverseuse sur laquelle est appliqué le signal OUTz. La porte 63 est de type OU, elle comprend une entrée inverseuse connectée à une sortie de la porte 62, une entrée non inverseuse sur laquelle est appliqué le signal TEST_MODE et une sortie sur laquelle est produit le signal ETAT.

Bien sûr, le mode de réalisation du circuit de comparaison 60 dépend notamment du nombre de cellules d'état choisi, des valeurs des signaux de référence appliqués sur leur première entrée, de la valeur du signal TEST_MODE lorsqu'il est actif, de la taille et de la rapidité du circuit global obtenu, etc. On doit simplement choisir un mode de réalisation tel que :
- le circuit 60 est actif uniquement en mode de fonctionnement normal (TEST_MODE inactif)
- le circuit 60 vérifie individuellement la valeur de chaque signal OUTa à OUTz par rapport à la valeur de référence associée ou vérifie une combinaison de ces signaux par rapport à une valeur associée d'une combinaison des valeurs de références appliquées respectivement sur la première entrée de chaque cellule d'état.

Le circuit 60 peut notamment être réalisé à partir d'un ensemble de portes logiques de type approprié, ou bien de comparateurs de tous types.

## Revendications

1. Circuit électronique comprenant :
• une pluralité de cellules configurables (2a, ..., 2Y, 2z) configurées, par un circuit de commande tel qu'un contrôleur d'accès (CTAP) lorsqu'il reçoit un signal de commande de mode (TEST_MODE) :
➢ soit dans un état fonctionnel dans lequel les cellules configurables sont fonctionnellement reliées à des cellules logiques (10 à 15) avec lesquelles elles coopèrent pour former au moins un circuit logique, si le signal de commande de mode est dans un premier état,
➢ soit dans un état chaîné dans lequel les cellules configurables sont fonctionnellement connectées en chaîne pour former un registre à décalage, si le signal de commande de mode est dans un deuxième état,
• un circuit de détection agencé pour produire un signal d'état (ETAT) actif s'il détecte un état chaîné des cellules configurables alors que le circuit de commande reçoit le signal de commande de mode dans le premier état,
dans lequel le circuit de détection comprend :
• une cellule d'état (40; 40a à 40z) comprenant une première entrée de données sur laquelle est appliqué un signal ayant une valeur de référence (SREF SREFa,...,SREFz), une deuxième entrée de données connectée à une sortie d'une cellule configurable précédente, une troisième entrée de sélection connectée au circuit de commande et une sortie connectée à une cellule configurable suivante, la cellule d'état étant:
➢ fonctionnellement connectée en chaîne entre la cellule configurable précédente (2y ; 2a, 2x) et la cellule configurable suivante (2z; 2b, 2y) si les cellules configurables sont dans l'état chaîné, la dite cellule d'état produisant un signal de sortie (OUT ; OUTa à OUTz) représentatif du contenu de la chaîne, ou
➢ fonctionnellement isolée si les cellules configurables sont dans l'état fonctionnel, la duite cellule d'état produisant alors un signal de sortie représentatif de la valeur de référence (SREF, SREFa,...,SREFz)
• un circuit de comparaison (50 ; 60) comprenant une première entrée de données connectée à la sortie de la cellule d'état et une deuxième entrée de données sur la.quelle est appliqué le signal de commande de mode, pour comparer le signal de sortie (OUT ; OUTa, ..., OUTz) avec la valeur de référence (SREF is SREFa,...,SREFz) lorsqu'il reçoit le signal de commande de mode (TEST_MODE), et produire le signal d'état (ETAT) actif si le signal de sortie n'est pas représentatif de la valeur de référence.

2. Circuit selon la revendication 1, dans lequel le circuit de détection comprend plusieurs cellules d'état (40a à 40z) qui sont :
• fonctionnellement connectées on chaîne avec les cellules configurables si les cellules configurables sont dans l'état chaîné, chaque cellule d'état (40a, 40z) étant connectée entre une cellule configurable précédente (2a, 2x) et une cellule configurable suivante (2b, 2y), chaque cellule d'état produisant un signal de sortie (OUTa, ..., OUTz) représentatif du contenu de la chaîne, ou
• fonctionnellement isolées si les cellule configurables sont dans l'état fonctionnel, chaque cellule d'état produisant alors un signal de sortie représentatif d'une valeur de référence parmi un ensemble de valeurs de référence. le circuit de comparaison (60) comparant le signal de sortie (OUTA, ..., OUTz) de chaque cellule d'état avec une valeur de référence associée lorsqu'il reçoit le signal de commande de mode (TEST_MODE) dans le premier état, et produire le signal d'état actif si la valeur d'un des signaux de sortie est différente de la valeur de référence associée.

3. Circuit selon l'une des revendications précédentes,
dans lequel la dite cellule configurable comprend également :
• une bascule ayant une sortie connectée a la sortie de la dite cellule configurable, et
• un multiplexeur ayant une première entrée de données et une deuxième entrée de données connectées respectivement à la première entrée et à la deuxième entrée de la cellule configurable, une entrée de sélection connectée à la troisième entrée de la dite cellule configurable, et une sortie connectée à une entrée de données de la bascule.

4. Circuit selon l'une des revendications 1 à 3, dans lequel le circuit de comparaison comprend :
• un circuit de logique combinatoire, pour combiner entre eux les signaux de sortie de plusieurs cellules d'état, et
• un moyen pour comparer le résultat de la combinais on avec la valeur de référence lorsqu'il reçoit le signal de commande de mode (TEST_MODE), et produire le signal d'état (ETAT) actif si le résultat de la combinaison est différent de la valeur de référence.

5. Circuit selon l'une des revendications 1 à 4, dans lequel au moins une cellule configurable est réalisée de manière similaire à une cellule d'état, la première entrée de données de la dite cellule configurable étant connectée à une sortie d'une cellule logique avec laquelle elle coopère.

## Claims

1. An electronic circuit comprising :
- a plurality of configurable cells (2a, ..., 2Y, 2z) configured by a control circuit such as a test access controller (CTAP) when it receives a mode command signal (TEST_MODE):
* either in a functional state in which the configurable cells are functionally linked to logic cells (10 to 15) with which they co-operate to form at least one logic circuit if the mode command signal is in a first state,
* or in a chained state in which the configurable cells are functionally connected in a chain to form a shift register, if the mode command signal is in a second state,
- a detection circuit laid out to produce an active state signal (STATE) if it detects a chained state of the configurable cells while the controller receives the mode command signal in the first state,
wherein the detection circuit comprises
- a state cell (40; 40a to 40z) comprising a first data input to which there is applied a signal having a reference value (SREF, SREFa, ..., SREFz), a second data input connected to the output of the preceding configurable cell, a third selection input connected to the controller and an output connected to the following configurable cell, the state cell being:
* functionally connected in a chain between a preceding configurable cell (2y; 2a, 2x) and a following configurable cell (2z; 2b, 2y) if the configurable cells are in the chained state, said state cell producing an output signal (OUT; OUTa to OUTz) representing the content of the chain, or
* functionally cut off if the configurable cells are in the functional state, said state signal then producing an output signal that represents the reference value (SREF, SREFa, ..., SREFz),
- a comparison circuit (50; 60) comprising a first data input connected to the output of the state cell and a second date input on which plied to a second data input of the comparison circuit, to compare the output signal (OUT ; OUTa, ..., OUTz) with the reference value when it receives the mode command signal (TEST_MODE) and produce the active state signal (STATE) if the value of the output signal is different from the reference value. (SREF, SREFa, ..., SREFz)

2. A circuit according to claim 1, wherein the detection circuit comprises several state cells (40a to 40z) which are:
• functionally connected in a chain with the configurable cells if the configurable cells are in the chained state, each state cell (40a, 40z) being connected between a preceding configurable cell (2a, 2x) and a following configurable cell (2b, 2y), each state cell producing an output signal (OUTa, ..., OUTz) representing the content of the chain or
• functionally cut off if the configurable cells are in the functional state, each state cell then producing an output signal representing one reference value among a set of reference values,
the comparison circuit (60) comparing the output signal (OUTA; ..., OUTz) of each state cell with a reference value when it receives the mode command signal (TEST_MODE) in the first state, and producing the active state signal if the value of one of the output signals is different from the associated reference value.

3. A circuit according to one of the preceding claims, wherein said configurable cell also comprises:
• a flip-flop circuit having one output connected to the output of said configurable cell, and
• a multiplexer having a first data input and a second data input respectively connected to the first input and to the second input of the configurable cell, a selection input connected to the third input of said configurable cell, and an output connected to the data input of the flip-flop circuit.

4. A circuit according to one of the claims 1 to 3, wherein the comparison circuit comprises:
• a combinatorial logic circuit to combine the output signals from several state cells with one another, and
• a means to compare the result of the combination with the reference value when it receives the mode command signal (TEST_MODE), and produce the active state signal (STATE) if the result of the combination is different from the reference value.

5. A circuit according to one of the claims 1 to 4, wherein at least one configurable cell is made similarly to a state cell, the first data input of said configurable cell being connected to one output of a logic cell with which it co-operates.

## Patentansprüche

1. Elektronischer Schaltkreis, umfassend:
mehrere konfigurierbare Zellen (2a, ..., 2Y, 2z), die durch eine Steuerschaltung, wie etwa eine Zugangssteuerung (CTAP). wenn diese ein Betriebsartsteuersignal (TEST_MODE) empfängt,
➢ entweder in einen Betriebszustand konfiguriert werden, in dem die konfigurierbaren Zellen funktionell mit logischen Zellen (10 bis 15) verbunden sind, mit denen sie zusammenarbeiten, um mindestens einen logischen Schaltkreis zu bilden, wenn sich das Betriebsartsteuersignal in einem ersten Zustand befindet,
➢ oder in einen verketteten Zustand, in dem die konfigurierbaren Zellen funktionell zu einer Kette geschaltet sind, um ein Schieberegister zu bilden, wenn sich das Betriebsartsteuersignal in einem zweiten Zustand befindet,
eine Erfassungsschaltung, derart eingerichtet, dass sie ein Zustandssignal (ETAT) erzeugt, das aktif ist, wenn sie einen verketteten Zustand der konfigurierbaren Zellen feststellt, während die Steuerschaltung das Betriebsartsteuersignal im ersten Zustand empfängt,
in dem die Erfassungsschaltung umfasst:
eine Zustandszelle (40; 40a bis 40z), die über einen ersten Dateneingang verfügt, an den ein Signal angelegt wird, das einen Bezugswert (SREF, SREFa, ..., SREFz) hat, einen zweiten Dateneingang, der an einen Ausgang einer vorangehenden konfigurierbaren Zelle angeschlossen ist, einen dritten Eingang zur Auswahl, der mit der Steuerschaltung verbunden ist, und einen Ausgang, der mit einer folgenden konfigurierbaren Zelle verbunden ist, wobei die Zustandszelle
➢ funktionell zwischen der vorangehenden konfigurierbaren Zelle (2y; 2a, 2x) und der folgenden konfigurierbaren Zelle (2z; 2b, 2y) zu einer Kette geschaltet ist, wenn sich die konfigurierbaren Zellen im verketteten Zustand befinden, wobei die genannte Zustandszelle ein Ausgangssignal (OUT; OUTa bis OUTz) erzeugt, das dem Inhalt der Kette entspricht, oder
➢ funktionell isoliert ist, wenn sich die konfigurierbaren Zellen im Betriebszustand befinden, wobei dann die genannte Zustandszelle ein Ausgangssignal erzeugt, das dem Bezugswert (SREF, SREFa, ..., SREFz) entspricht,
eine Vergleicherschaltung (50; 60), die einen ersten Dateneingang aufweist, der mit dem Ausgang der Zustandszelle verbunden ist, und einen zweiten Dateneingang, an den das Betriebsartsteuersignal angelegt wird, um das Ausgangssignal (OUT; OUTa bis OUTz) mit dem Bezugswert (SREF, SREFa, ..., SREFz) zu vergleichen, wenn sie das Betriebsartsteuersignal (TEST_MODE) empfängt, und das aktive Zustandssignal (ETAT) zu erzeugen, wenn das Ausgangssignal dem Bezugswert nicht entspricht.

2. Schaltkreis nach Patentanspruch 1, in dem die Erfassungsschaltung mehrere Zustandszellen (40a bis 40z) umfasst, die
mit den konfigurierbaren Zellen funktionell zu einer Kette geschaltet sind, wenn die konfigurierbaren Zellen sich im verketteten Zustand befinden, wobei jede Zustandszelle (40a, 40z) zwischen eine vorangehende konfigurierbare Zelle (2a, 2x) geschaltet ist und eine folgende konfigurierbare Zelle (2b, 2y), wobei jede Zustandszelle ein Ausgangssignal erzeugt (OUTa, ..., OUTz), das dem Inhalt der Kette entspricht, oder
funktionell isoliert ist, wenn sich die konfigurierbaren Zellen im Betriebszustand befinden, wobei dann jede Zustandszelle ein Ausgangssignal erzeugt, das einem Bezugswert aus einer Reihe von Bezugswerten entspricht,
wobei die Vergleicherschaltung (60) das Ausgangssignal (OUTa, ..., OUTz) jeder Zustandszelle mit einem zugehörigen Bezugswert vergleicht, wenn sie das Betriebsartsteuersignal (TEST_MODE) im ersten Zustand empfängt, und das aktive Zustandssignal erzeugt, wenn sich der Wert eines der Ausgangssignale vom zugehörigen Bezugswert unterscheidet.

3. Schaltkreis nach einem der vorangehenden Patentansprüche, in dem die genannte konfigurierbare Zelle außerdem umfasst:
eine Kippschaltung, deren einer Ausgang mit dem Ausgang der genannten konfigurierbaren Zelle verbunden ist, und
einen Multiplexer mit einem ersten Dateneingang und einem zweiten Dateneingang, die mit dem ersten Eingang bzw. dem zweiten Eingang der konfigurierbaren Zelle verbunden sind, einem Auswahleingang, der mit dem dritten Eingang der genannten konfigurierbaren Zelle verbunden ist und einem Ausgang, der mit einem Dateneingang der Kippschaltung verbunden ist.

4. Schaltkreis nach einem der Patentansprüche 1 bis 3, in dem die Vergleicherschaltung umfasst:
eine kombinatorische Logikschaltung zum Kombinieren der Ausgangssignale mehrerer Zustandszellen miteinander, und
ein Mittel zum Vergleichen des Ergebnisses der Kombination mit dem Bezugswert, wenn es das Betriebsartsteuersignal (TEST_MODE) empfängt, und Erzeugen des aktiven Zustandssignals (ETAT), wenn sich das Ergebnis der Kombination vom Bezugswert unterscheidet.

5. Schaltkreis nach einem der Patentansprüche 1 bis 4, in dem mindestens eine konfigurierbare Zelle in ähnlicher Weise hergestellt wird, wie eine Zustandszelle, wobei der erste Dateneingang der genannten konfigurierbaren Zelle mit einem Ausgang einer Logikzelle verbunden ist, mit der sie zusammenarbeitet.
